# EUROPÄISCHE PATENTANMELDUNG

(11) **EP 1 566 472 A2**
(43) Veröffentlichungstag der Anmeldung: **24.08.2005**
(21) Anmeldenummer: 05003901.5
(22) Anmeldetag: 23.02.2005
(51) Int. Cl.: C30B 33/00, C30B 29/12, G02B 5/30

(54) **Herstellung von spannungsarmen, nicht (111)-orientierten, grossvolumigen Einkristallen mit geringer Spannungsdoppelbrechung und homogener Brechzahl, sowie deren Verwendung**

(30) Priorität: 23.02.2004 DE 102004008754
(71) Anmelder: Schott AG, 55122 Mainz (DE)
(72) Erfinder: Parthier, Lutz, Dr., 14532 Kleinmachnow (DE); Stäblein, Jörg, 07743 Jena (DE); Wehrhan, Gunther, Dr., 07749 Jena (DE); Kusch, Dr. Christian, 81667 München (DE)
(74) Vertreter: Fuchs Mehler Weiss & Fritzsche

(57) **Zusammenfassung**

Es wird ein Verfahren zur Herstellung von insbesonders nicht 111-orientierten, Gleitebenen aufweisenden spannungsarmen, großvolumigen Kristallen mit geringer Spannungsdoppelbrechung und homogener Brechzahl beschrieben. Das Verfahren umfasst Züchten und Tempern eines Kristalles unter Relaxierung von Spannungen entlang seiner Gleitebenen durch Zuführen von Wärme unter Ausbildung eines Temperaturgradienten, wobei beim Tempern die Richtung der Wärmezufuhr und/oder beim Abkühlen der Wärmeabfuhr über eine Richtung erfolgt, die mit den Gleitebenen einen Winkel von 5 - 90° bildet. Mit diesem Verfahren werden Kristalle mit einer homogenen Brechzahl von < 0,025 x 10⁻⁶ (RMS-Wert) erhalten.

## Beschreibung

Die Erfindung betrifft die Herstellung von nicht (111)-orientierten, spannungsarmen, großvolumigen Einkristallen, die über ihr Volumen hinweg eine geringe Doppelbrechung und eine homogene Brechzahl aufweisen, mittels einem gerichteten Tempern, die Verwendung derartiger Kristalle, sowie derartige Kristalle und optische Elemente, die solche Kristalle umfassen.

Durch die Notwendigkeit Linsen und optische Systeme auch für Wellenlängen außerhalb des für den Menschen sichtbaren Bereiches zu verwenden, finden immer häufiger Kristalle, insbesonders Einkristalle Verwendung. So werden beispielsweise bei der Herstellung von Computerchips mittels Mikrolithographie zum Belichten Laserstrahlen im tiefen UV-Bereich (DUV) insbesonders bei Wellenlängen unter 250 nm, speziell bei 248 nm, 193 nm bzw. 157 nm eingesetzt. Als optische Elemente bzw. Linsen in Beleuchtungs- und Abbildungsoptiken bei 193 nm und vorzugsweise bei 157 nm werden große Einkristalle verwendet. Als ein bevorzugtes Material hierfür hat sich CaF₂ durchgesetzt. Zur Herstellung integrierter Schaltungen, z. B. Computerchips, ist es notwendig, dass derartige Optiken auch kleinste Strukturen fehlerfrei, d. h. scharf abbilden, um ein einwandfreies Produkt zu erhalten. Um die hierfür notwendige Abbildungsqualität zu erreichen, werden an das optische Grundmaterial, d. h. an den Kristall, sehr hohe Anforderungen gestellt. Dabei soll die Brechzahl Δn so homogen wie möglich sein, d. h. deren Schwankungen im Linsenrohling soll nicht mehr als 1*10⁶ betragen und die Spannungsdoppelbrechung soll deutlich unter 1 nm/cm liegen.

Es sind daher bereits eine Vielzahl von Verfahren zur Herstellung großvolumiger Einkristalle für den genannten Zweck bekannt. So beschreibt beispielsweise die DE-A 100 10 484 eine Vorrichtung zum Züchten von großvolumigen Einkristallen und die DE-A 100 10 485 ein Verfahren zum Tempern derartiger Kristalle zur Reduzierung der Spannungsdoppelbrechung. Dabei wird üblicherweise von Kristallen ausgegangen, die vor dem Tempern eine durchschnittliche Spannungsdoppelbrechung (RMS-Werte) von ca. 5 - 20 nm/cm aufweisen. Mit den beschriebenen Verfahren lässt sich die Spannungsdoppelbrechung an Kristallen auf bis zu 1 nm/cm verringern und die Brechzahlen derart konstant halten, dass innerhalb eines Kristalles die Brechzahlen um nicht mehr als Δn = 5*10⁻⁶ von einander abweichen. Dabei wird der fertig gezüchtete Kristall in einen Temperofen eingebracht und mindestens 2 Stunden lang oberhalb 1150°C im Beisein eines die Verdampfung des Kristalles verringernden CaF₂-Pulvers erwärmt. Auch in der DD-PS-213514 wird ein Temperverfahren beschrieben, bei dem ein CaF₂-Kristall in einer PbF₂-haltigen Atmosphäre bei einer Temperatur von 1200°C erhitzt wird, wobei im Kristall eine vorliegende Spannungsdoppelbrechung von 10 - 25 nm/cm (RMS-Wert) durch eine 2 - 3-stündige Erwärmung auf 1200°C auf nur 1 nm/cm verringert wird.

In der JP-A 2001-335 398 wird ein Temperverfahren zum Abbau der Spannungsdoppelbrechung und zur Erhöhung der Homogenität des Brechungsindexes beschrieben, wobei der Kristall zuerst in einem Bereich von 1020 - 1150°C für eine vorgegebene Zeit erwärmt wird und mit einer Abkühlgeschwindigkeit von 1°C pro Stunde dann auf eine Temperatur unterhalb 700°C abgekühlt wird.

Beim Tempern erfolgt nämlich ein mehr oder weniger vollständiger Abbau von im Kristall vorhandenen Spannungen über eine plastische Verformung im Kristallgitter durch Aktivierung von Gleitprozessen entlang der durch die jeweilige Struktur des Kristallgitters vorgegebenen Gleitsysteme sowie über atomare Diffusionsmechanismen (Kletterprozesse). Daher ist es, um ein über das gesamte Kristallvolumen hindurch defektarmen Kristall zu erreichen, notwendig, dass eine möglichst hohe Temper- oder Annealingtemperatur eingestellt wird; wobei generell gilt, je höher die Temperatur desto geringer ist die verbleibende Restspannung, wobei dem Kristall ausreichend Zeit gegeben werden muss, damit die gewünschten Gleit- und Diffusionsprozosse ablaufen können. Hierbei soll möglichst während des gesamten Temperprozesses, bestehend aus Aufheizphase, Haltezeit bei Maximaltemperatur und Abkühlphase, eine extrem homogene Temperaturverteilung im gesamten Kristallvolumen gewährleistet sein. Die räumliche Temperaturverteilung im gesamten Kristallvolumen ergibt sich aus der Überlagerung statischer Temperaturgradienten (anlagenbedingte Temperaturverteilung) mit den dynamischen Temperaturgradienten, welche infolge von Aufheiz- bzw. Abkühlvorgängen im Kristall entstehen. Erstere dominieren die Haltezeit, letztere kommen vor allem in der Aufheiz- und Abkühlphase zum tragen.

Dabei wurde bislang davon ausgegangen, dass die Orientierung des Kristalls im Temperaturfeld irrelevant für das Temperergebnis ist, da sich das Volumen bei Maximaltemperatur(Haltetemperatur) lange in einem wesentlich homogeneren, statischen Temperaturfeld befindet, als das in der Aufheizphase oder der Abkühlphase der Fall ist.

Um das durch das Tempern erzeugte mehr oder weniger spannungsfreie Kristallgefüge zu erhalten, wird dann derart abgekühlt, dass möglichst kein Temperaturgradient im Kristall erzeugt wird, der neue Spannungen hervorruft.

Das Tempern kann als Prozessschritt unmittelbar in der Kristallzuchtanlage oder aber auch als separater Prozess in einem speziellen Ofen ausgeführt werden.

Ausgehend von theoretischen Betrachtungen zwischen der Dimension von Kristallkörpern wie Durchmesser und Dicke und im Material auftretenden, die Spannungsdoppelbrechung hervorrufenden Spannungen müssen Kristalle in möglichst kleinen Dimensionen getempert werden. Da die durch beim Erwärmen bzw. Abkühlen im Kristall zwischen verschiedenen Orten zwangsläufig auftretenden Temperaturunterschiede ΔT hervorgerufenen Spannungen proportional zum Quadrat der Dicke bzw. Höhen des Kristalls und proportional dem Quadrat des Durchmessers d einer Scheibe sind, d. h. ΔT~d² und ΔT~h², ist bislang davon ausgegangen worden, die Kristalle mit möglichst geringstem Volumen zu Tempern. Dabei bewirkt eine Vergrößerung des Durchmessers bzw. Höhe oder Dicke des Kristallkörpers beim Tempern unter sonst identischen Bedingungen eine Zunahme der Spannungsdoppelbrechung.

In der JP-A 10-251 096 wird daher beschrieben, den Kristall vor dem Tempern auf eine für das Endprodukt endmaßnahe Dimension zurecht zu schneiden und anschließend einem Temperverfahren zu unterziehen.

Einige typische Vorgehensweisen beim Tempern von Calciumfluorid wurden bereits in der EP 0 939 147 A2 oder in der US 6,332,922 B1 beschrieben. Dabei werden insbesondere die Temperatur-Zeit-Bedingungen beschrieben, um Calciumfluoridkristalle bezüglich ihrer Spannungsdoppelbrechung und Brechzahlhomogenität zu verbessern. Die beschriebenen Verfahren führen jedoch nicht zu Kristallen, die die erforderliche Qualität für die inzwischen aktuellen Anforderungen der Mikrolithographie bei Anwendungswellenlängen von 193 nm bzw. 157 nm erreichen.

Die Verknüpfung zwischen mechanischen Größen (wie z. B. Spannungen) und der durch sie verursachten optischen Wirkung (wie z. B. die Spannungsdoppelbrechung SDB) ist im Kristall (richtungsabhängig) über den spannungsoptischen Tensor gegeben. Das bedeutet, Spannungen gleicher Größe können in einem einkristallinen Material in Abhängigkeit von der kristallographischen Orientierung bzw. der Beobachtungsrichtung zu deutlich unterschiedlicher Spannungsdoppelbrechung und Brechzahlhomogenität führen. Aus diesem Grunde wurden bisher Bauelemente eingesetzt, bei denen die minimale Spannungsdoppelbrechung in der Anwendungsrichtung zu beobachten ist. Das ist für Calciumfluorid in der (111)-Richtung der Fall. Bisher wurde daher Material ausschließlich in der Orientierung (111) für Rohlinge (bzw. (111)-nahe für Kuben) eingesetzt.

Die Untersuchungen von J.H. Burnett, Z.H. Levine, E.L. Shirley, "Intrinsic birefringence in calcium fluoride and barium fluoride", Physical Rev. B 64 (2001) 241102 haben gezeigt, dass das Calciumfluorid intrinsisch doppelbrechend wirkt. Dieser Effekt nimmt in der Nähe der Bandkante des Materials stark zu und führt bei einer Anwendungswellenlänge von 157nm zu deutlichen Abbildungsfehlern. Um diese intrinsische Doppelbrechung kompensieren zu können, werden von den Objektivherstellern Linsen unterschiedlicher Kristallorientierung kombiniert. Daraus ergibt sich die Notwendigkeit, Linsenrohlinge, Quader und Prismen verschiedener Kristallorientierung, speziell in (100)- und (110)-Orientierung, zu fertigen.

Die Anforderungen an die nicht-(111)-orientierten Produkte bezüglich der optischen Qualität, speziell der Brechzahlhomogenität und Spannungsdoppelbrechung sind vergleichbar mit den Anforderungen, die an das (111)-Material gestellt werden. Allerdings sind diese Anforderungen an die Qualität für nicht-(111)-orientierte Produkte ungleich schwerer erreichbar. Die Restspannungen im Material müssen für (100) bzw. (110)-orientierte Produkte um 80 bis 90% geringer sein als für (111)-orientierte Produkte, wenn die gleiche Spannungsdoppelbrechung erreicht werden soll.

In EP 0 942 297 A2 wird beschrieben, dass aufgrund der Anisotropie des spannungsoptischen Verhaltens für Lithographieanwendungen die (111)-Orientierung von Rohlingen bzw. Halbzeugen zu bevorzugen ist. Dabei wurden die (111), (100), (110)-Orientierungen untersucht und es wurde gefunden, dass bei gleichartiger Wärmebehandlung von CaF₂-Scheiben unterschiedlicher Orientierung nur die (111)-Scheibe Spannungsdoppelbrechungswerte nahezu im geforderten Bereich erreicht.
Am Beispiel von BaF₂-Scheiben wird gezeigt, dass auch die erreichte Reduzierung der SDB durch die Wärmebehandlung für die (111)-Scheibe wesentlich größer ist, als die für nicht (111)-orientierte Scheiben.

Wie CaF₂ mit von (111) verschiedener optischer Hauptrichtung in der geforderten Qualität produziert werden kann, ist bislang nicht bekannt.

Die Erfindung hat daher zum Ziel, durch Temperung bei erhöhter Temperatur in einem geeigneten Ofen bzw. einer zum Tempern geeigneten Anlage Kristalle, insbesonders CaF₂-Kristalle in einer optischen Qualität herzustellen, die für den Einsatz mit einer von (111) verschiedenen optischen Hauptrichtung, speziell (100) bzw. (110), in der Mikrolithographie bei Wellenlängen von 193 nm oder kürzer erforderlich ist.

Dieses Ziel wird durch die in den Ansprüchen definierten Merkmale erreicht.

Es wurde nämlich überraschenderweise gefunden, dass eine Verbesserung der optischen Eigenschaften von derartigen Kristallen dann erfolgt, wenn beim Tempern ein insbesonders geringer radialer Temperaturgradient im Temperofen erzeugt wird, der in einem Winkel von mindestens 5° von der Gleitebene des im Temperofen positionierten Tempergutes abweicht.
Auch der axiale Temperaturgradient im Temperofen muss so gering wie möglich einstellbar sein.

Die Richtung des maximalen Temperaturgradienten ist gleichzeitig die Richtung der höchsten Spannungen. Da der Kristall sich nur entlang bestimmter Gleitrichtungen auf bestimmten Gleitebenen plastisch verformt, ist für die Verformung nur die in diesem Gleitsystem wirksame Spannung für die Verformung relevant.

Im Falle des CaF₂ ist die Hauptgleitebene die (100)-Ebene. Treten die maximalen Temperaturgradienten parallel bzw. senkrecht zur Oberfläche einer 100-Scheibe auf, sind die Spannungen im Gleitsystem voll wirksam. Durch Verkippen der Scheibenorientierung werden die wirksamen Spannungen reduziert. Im Falle der 111-Orientierung (Der Winkel zwischen 111-Oberfläche und 100-Gleitebene beträgt 54,73°) ist diese wirksame Spannungskomponente deutlich reduziert. Der beste denkbare Fall wäre in diesem Sinne eine (110)-Orientierung. In diesem Falle aber würde das zweite (Neben-)gleitsystem mit 110 als Gleitebene extrem günstig orientiert sein und aktiviert werden.

Es ist bevorzugt, dass zwischen Gleitrichtung und Richtung des maximalen Temperaturgradienten ein Winkel von größer 5° insbesonders größer 10°, d. h. 5°-85° insbesonders 10°-80° eingeschlossen wird. Für CaF₂-Kristalle und damit vergleichbare Strukturen sind Winkel von 25° bis 36° besonders bevorzugt. In anderen Kristallsystemen können auch größere Winkel erreicht werden. Gemäß der Lehre der Erfindung ist es bevorzugt, den maximal möglichen Winkel zwischen Gleitrichtung und Richtung des Temperaturgradienten einzustellen.

Besonders bevorzugt wird der Kristall in seiner (111)-Richtung getempert und zwar so, dass diese (111)-Achse parallel zur Achse des verwendeten Temperofens verläuft. Dabei ist es bevorzugt, dass der im Temperofen erzeugte radiale Temperaturgradient parallel zur Erdoberfläche verläuft, bzw. senkrecht zur Erdanziehung.

Die extremen Anforderungen an die Spannungsfreiheit der Kristalle werden insbesonders dann erfüllt, wenn neben der Reduzierung der dynamischen Temperaturgradienten durch Heiz- und Kühlprozesse auch die statischen Temperaturgradienten in der Anlage verringert werden. Statische Temperaturgradienten werden durch die räumliche Temperaturverteilung (Ofendesign) im Temperofen verursacht. Sie treten auch in der Haltezeit auf.
Dynamische Temperaturgradienten treten im Tempergut auf, wenn von außen (Ofen) Wärme zu- oder abgeführt wird. Ein Wärmetransport bedingt Temperaturgradienten im Material und die Größe dieser Gradienten wird wesentlich von den Aufheiz- und Abkühlgeschwindigkeiten bestimmt. Diese Gradienten werden hier als dynamische Temperaturgradienten bezeichnet.
In Aufheiz- und Abkühlphasen überlagern sich beide Arten von Gradienten.

Für das erfindungsgemäße Tempern ist es notwendig, dass die von außen dem Kristall zugeführte Wärme beim Aufwärmen des Kristalls einen geringen, jedoch keinen zu großen Temperaturgradienten erzeugt. Erfindungsgemäß hat es sich als zweckmäßig erwiesen, diese sich beim Aufheizen herausbildenden radialen und axialen dynamischen Temperaturgradienten durch die Aufheizgeschwindigkeit derart zu begrenzen, dass an keiner Stelle des Kristalles, gemessen zum gleichen Zeitpunkt, sich ein Temperaturunterschied von mehr als 5°C einstellt. Vorzugsweise beträgt die Obergrenze der Temperaturunterschiede insbesonders im Kristall maximal 2°C, wobei maximal 1°C besonders bevorzugt ist. Dies wird bei der erfindungsgemäßen Vorgehensweise dadurch erreicht, dass beim Aufheizen Raten von weniger als 18K/h eingestellt werden, vorzugsweise weniger als 12K/h wobei Aufheizraten von weniger als 10K/h besonders bevorzugt sind. Erfindungsgemäß wurde auch gefunden, dass geringe Aufheizraten wesentlich sind, um ein gutes Temperendergebnis zu erreichen. Es hat sich nämlich gezeigt, dass auch während des Aufheizens generierte Defekte im Falle von nicht in (111)-Orientierung senkrecht zur Erdoberfläche angeordneten Kristallen sich einerseits wesentlich störender auf das Endergebnis auswirken und andererseits (auch während der Haltezeit) wesentlich schwerer relaxieren.

Es ist auch bevorzugt, dass diese maximalen Temperaturunterschiede nicht in einem inneren Volumenbereich des Kristalls auftreten; d. h. in einem Bereich, der mindestens 10% des Kristalldurchmessers vom Kristallrand entfernt ist. Obwohl es nicht bevorzugt ist, können daher im Randbereich geringfügige höhere Temperaturunterschiede herrschen, als die zuvor angegebenen.

Nach dem Aufheizen, d.h. während der Haltezeit bei maximaler Tempertemperatur bilden sich im Temperraum statische Temperaturgradienten in radialer und axialer Richtung heraus. Durch die Ofenkonfiguration werden gemäß der vorliegenden Erfindung diese auf maximal 0,2K/cm begrenzt. Vorzugsweise werden jedoch statische, radiale Temperaturgradienten im Temperraum von kleiner als 0,013K/cm und statische axiale Temperaturgradienten im Temperraum von kleiner als 0,07K/cm gewährleistet.

Erfindungsgemäß ist es bevorzugt, den Kristall beim Tempern mittels einer Graphitauflage abzudecken. Bevorzugt sind Graphitmatten oder Graphitplatten. Graphitplatten tragen zur Verringerung des Temperaturgradienten im Tempergut bei, indem eine gleichmäßige Wärmezu- und -abfuhr in bzw. aus dem Kristall befördert wird. Die Graphitabdeckungen haben eine gute Wärmeleitfähigkeit. Obwohl es erfindungsgemäß bevorzugt ist, das Tempern mittels einer im Ofen seitlich angeordneten Heizung durchzuführen und dabei die Wärmezufuhr und den somit entstehenden Gradienten seitlich, d. h. parallel zur Erdoberfläche auf den Kristall einwirken zu lassen, so ist es auch möglich dies mittels einer Deckel- und Bodenheizung durchzuführen; dabei hat es sich als zweckmäßig erwiesen, besonders gut wärmeleitende Graphitplatten auf den Kristall zu legen.

Es hat sich als zweckmäßig erwiesen, beim Tempern zuerst auf eine Temperatur von 350°C - 600°C, insbesondere 350°C - 500°C zu erwärmen, um bei der Bearbeitung des Calciumfluorid-Kristalls sowie bei der Lagerung eingebrachtes Wasser zu entfernen. Besonders bevorzugt ist eine Erwärmung von 350°C - 400°C. Dies geschieht vorzugsweise unter Vakuum. Die Wassertrocknung beträgt üblicherweise 12 - 45 Stunden, vorzugsweise 24 Stunden.

Es hat sich gezeigt, dass sich die Kristalldefekte im CaF₂ hinreichend weit reduzieren lassen, um die genannten Ziele zu erreichen, wenn der Kristall auf Temperaturen von über 1000°C erwärmt wird und bei der eingestellten Temperatur wenigstens 65 Stunden, vorzugsweise mindestens 75 Stunden gehalten wird, wobei mindestens 80 Stunden besonders bevorzugt sind. Erfindungsgemäß wurde gefunden, dass entgegen bisherigen Vorstellungen diese gegenüber bisher bekannten Prozessen deutlich verlängerte Zeit erforderlich ist, um die notwendigen Relaxationsvorgänge im Kristall ablaufen zu lassen.

Die einzustellende Haltetemperatur beträgt erfindungsgemäß mindestens 1000°C, vorzugsweise mindestens 1050°C, wobei mindestens 1080°C bzw. 1100°C besonders bevorzugt sind. Ganz besonders bevorzugt ist ein Tempern oberhalb 1200°C, wobei oberhalb 1210°C besonders bevorzugt ist. Als obere Tempergrenze sollte 1415°C vorzugsweise 1370°C nicht überschritten werden. Die Obergrenzen betragen maximal 1360°C, wobei 1350°C bevorzugt ist. Zweckmäßige Obergrenzen betragen erfindungsgemäß 1300°C, wobei eine maximale Temperatur von 1250°C bzw. 1200°C meist ausreichend ist. Erfindungsgemäß hat es sich auch als vorteilhaft erwiesen, dass während der Haltezeit möglichst keine oder nur minimale Temperaturunterschiede im Kristall auftreten, d. h. dass die Temperatur über das gesamte Kristallvolumen hinweg möglichst gleich bzw. homogen ist.

Vorzugsweise sind erfindungsgemäß beim Aufheizen Raten von weniger als 18K/h einzustellen, vorzugsweise weniger als 12K/h, wobei Aufheizraten von weniger als 10K/h besonders bevorzugt sind. Erfindungsgemäß wurde auch gefunden, daß geringe Aufheizraten wesentlich sind, um ein gutes Temperendergebnis zu erreichen. Es hat sich nämlich gezeigt, daß auch während des Aufheizens generierte Defekte im Falle von nicht (111)-orientierten Blanks sich einerseits wesentlich störender auf das Endergebnis auswirken und andererseits wesentlich schwerer (während der Haltezeit) relaxieren.

Der Erfolg der in der Haltezeit bei den sehr geringen statischen Temperaturgradienten abgelaufenen Relaxationsprozesse darf durch ein zu schnelles Abkühlen nicht zunichte gemacht werden. Das Abkühlen muss so langsam erfolgen, dass die während der Haltezeit existent gewesenen statischen Temperaturgradienten sich nicht unwesentlich verschlechtern. Wird also an verschiedenen Zeitpunkten während des Abkühlprozesses an verschiedenen Orten innerhalb des Tempergefäßes die Temperatur gemessen, dann dürfen die als dynamische Temperaturgradienten bezeichneten Gradienten nur unwesentlich schlechter sein als während der Haltezeit. Gemäß der vorliegenden Erfindung sind beim Abkühlen Raten einzuhalten, welche im oberen Temperaturbereich der Abkühlphase kleiner 0,5K/h, vorzugsweise kleiner 0,4 K/h, und insbesondere kleiner 0,3 K/h betragen und in einem unteren Temperaturbereich der Abkühlphase größer sein können.

Die Erhöhung der Abkühlraten in dem unteren Temperaturbereich ist wünschenswert und auch möglich, um die Prozesszeit und die damit verbundenen Kosten nicht unnötig zu erhöhen. Die Erhöhung der Abkühlrate kann in einem Schritt, bevorzugt aber in mehreren Schritten erfolgen. Die Temperaturraten im unteren Temperaturbereich dürfen gemäß dieser Erfindung nicht über 3 K/h, bevorzugt nicht über 2 K/h, insbesondere nicht über 1,7 K/h erhöht werden.

Die Grenztemperatur, welche den oberen von dem unteren Temperaturbereich der Abkühlphase trennt, liegt in dem Bereich zwischen 900°C und 600°C. Die Übergangstemperatur liegt dabei umso tiefer, je höher die Qualitätsanforderungen an das Produkt sind.

Die Anlage sollte vorzugsweise in ihrem Inneren ausschließlich aus hochreinem Graphit bestehen, um Kontaminationen der CaF₂-Kristalle auszuschließen, welche zu einer Minderung der Transmission führen können.

Die Anforderungen an die Reinheit bestehen ebenso an die zu tempernden Produkte. Vor Beschickung der Anlage sind daher die Teile einer sorgfältigen Reinigung zu unterziehen. Die Teile sollen sowohl fett- und staubfrei sein, sowie möglichst keine Oberflächenfeuchte ausweisen. Bevorzugt wird daher eine Reinigung der Teile mit fettlösenden organischen Lösungsmitteln mit hohem Dampfdruck. Nach erfolgter Reinigung ist jede Berührung der Teile mit bloßer Haut oder verschmutzten Gegenständen zu vermeiden.

Es hat sich auch als zweckmäßig erwiesen, das Tempern unter Schutzgas durchzuführen. Übliche Schutzgase sind Stickstoff, Helium, Argon und/oder Xenon.

Zur Entfernung des in der Anlage, an der Kristalloberfläche bzw. im Kristallgitter vorhandenen Restsauerstoffs wird vorzugsweise wenigstens ein Scavenger-Material eingesetzt. Als vorteilhaft erweisen sich Verbindungen wie ZnF₂, PbF₂, XeF₂, SnF₂, welche als Feststoffe zugesetzt werden. Es ist auch möglich, nach einer ausgeprägten Trockenphase gasförmige Scavenger einzusetzen. Hierbei sind besonders Fluorgas, Fluorgas/Inertgasmischungen, Fluorkohlenstoffgase bzw. Fluorkohlenwasserstoffgase vorteilhaft zu verwenden. Eine Kombination von fest- und gasförmigen Scavengern kann auch verwendet werden.

In einer bevorzugten Ausführungsform wird die Temperung unter Einsatz von gasförmigem Scavenger vorgenommen, und zwar vorzugsweise in einer fluorhaltigen Atmosphäre, insbesondere einem fluorhaltigen Schutzgas, beispielsweise CF₄, C₂F₆, C₃F₈ oder CHF₃, SF₆ oder NF₃ bevorzugt unter dem Einsatz von Fluorkohlenstoffgasen, welche mit Inertgas vermischt in einer Konzentration von 1-50%, insbesondere 5-30%, speziell 5-15% in die Anlage eingebracht wird. Hierbei wird Fluorgas in einen Temperofen bzw. in ein das Tempergut enthaltendes Tempergefäß eingeleitet und/oder durch Verdampfen freigesetzt. Weitere reaktive Fluorgase sind Tetrafluormethan sowie andere Fluorkohlenstoffe oder Fluorkohlenwasserstoffe. Durch den Einsatz dieses Gases gelingt es überraschenderweise die Transmission des CaF₂ zu erhöhen. Dieser Effekt wird nicht bei Einsatz von Inertgas, Vakuum oder pulverförmigen Scavengermaterial erreicht.

Eine besonders bevorzugte fluorhaltige Atmosphäre ist eine HF-Atmosphäre. In einer weiteren bevorzugten erfindungsgemäßen Ausführungsform wird die fluorhaltige Atmosphäre zusammen mit einem Schutzgas verwendet. Zweckmäßigerweise enthält die dabei entstehende Gasmischung 0,1-20% Fluorgas, insbesondere 1-10%. Eine besonders bevorzugte Mischung ist eine Mischung aus HF und N₂.

In einer ganz besonders bevorzugten Ausführungsform wird die fluorhaltige Atmosphäre in Form von fluorfreisetzenden Festkörpern wie beispielsweise XeF₂ eingebracht. XeF₂ ist bei Raumtemperatur ein Festkörper, der sich bei einer Temperatur oberhalb 400°C zu Xe und F₂-Gas zersetzt. Zweckmäßigerweise wird es luftdicht verschlossen in einen Teflonbeutel eingesetzt.

Es hat sich als besonders zweckmäßig erwiesen, dass das Tempern in einer reduzierenden Atmosphäre durchgeführt wird. Eine reduzierende Atmosphäre wird beispielsweise durch den Zusatz von Grafitpulver erreicht, welches mit Wasser unter Ausbildung von CO/CO₂ und CH₄ reagiert, wobei CH₄ selbst eine reduzierende Wirkung aufweist. Auch das teilweise gasförmige Bleifluorid weist gegenüber Calciumoxid eine reduzierende sauerstoffentziehende Wirkung auf. Auf diese Weise können im Calciumkristall vorliegendes oder durch Wasseranlagerung entstandenes Calciumoxid zu Calciumfluorid umgewandelt werden, was sowohl der Schleierbildung als auch der Verringerung von Kleinwinkelkorngrenzen dient.

In besonderer Weise bevorzugt wird eine Ausführung wie zuvor beschrieben, bei der während des Temperprozesses ein Gasgemisch mit der zuvor angegebenen Zusammensetzung mit einem Durchfluss von wenigen Litern pro Minute durch die Anlage strömen lässt.

Bei besonderer Sorgfalt bezüglich der Reinheit und Sauerstofffreiheit aller in der Anlagen befindlichen Materialien und Oberflächen kann auf ein Scavengermaterial verzichtet werden. Dabei ist zunächst eine Trocknung im Hochvakuum auszuführen, um adsorbiertes Oberflächenwasser und Sauerstoff vollständig zu entfernen. Die Temperung kann im Vakuum, aber auch in einer Inertgasatmosphäre stattfinden.

Auch hat es sich als zweckmäßig erwiesen, im Inneren des das Tempergut enthaltenden Tempergefäßes einen Calciumfluorid-Partialdruck von 0,7-1,5 mbar, insbesondere 0,8-1 mbar aufrecht zu erhalten. Die wird vorzugsweise durch Beigabe von CaF₂-Pulver als Temperpulver in das Tempergefäß erreicht. Dabei ist das Tempergefäß vorzugsweise derart ausgestaltet, dass es nicht gasdicht ist. Der Abtransport von Gasen aus dem Inneren des Tempergefäßes wird so nur behindert, aber nicht verhindert. Der Grad der Behinderung des Abtransportes von Gasen ist so bemessen, dass in der Trocknungsphase zwischen 350°C und 600°C, insbesondere 350°C und 500°C und besonders bevorzugt 350°C bis 400°C, das von der Oberfläche des Tempergutes bzw. des Tempergefäßes entfernte Wasser bzw. die entfernten Gase ausreichend gut in das Volumen außerhalb des Tempergefäßes entweichen können. Gleiches gilt für die Heranführung und den Abtransport von Schutzgasen bzw. gasförmigen Scavengern. In den oberen Temperaturbereichen (höher als 600°C) bewirkt die nicht gasdichte Gestaltung des Tempergefäßes die Aufrechterhaltung des bereits genannten CaF₂-Partialdruckes und im Falle der zusätzlichen Verwendung von festen Scavengern einen je nach Scavengerart, Temperaturbereich und zugegebener Menge an Scavenger bestimmten Scavengerpartialdruck. Über große Temperaturbereiche herrschen dadurch für bestimmte Stoffe quasistationäre Zustände, solange noch ausreichend Temperpulver, Scavengerpulver und/oder Schutz- bzw. Fluorgas vorhanden ist.

Vorzugsweise wird beim Tempern ein feinteiliges Calciumfluoridpulver mit einer mittleren Korngröße von 100 nm - 1 mm verwendet. Übliche mittlere Korngrößen betragen 1 - 200 µm, vorzugsweise 5 - 100 µm und insbesondere von 10 - 50 µm. Die Oberfläche des feinteiligen Calciumfluoridpulvers sollte mindestens das 10fache, vorzugsweise mindestens das 100fache der Oberfläche des zu tempernden Gutes betragen. In besonders bevorzugten Ausführungsformen weist das Pulver mindestens das 1.000fache, in manchen Fällen mindestens das 5.000fache oder sogar 10.000fache der Oberfläche des Tempergutes auf.

Besonders bevorzugt ist es, die zu tempernden Kristalle und gefertigten Optiken direkt in das Temperpulver einzubetten, so dass dies einen innigen direkten Kontakt zum Pulver hat. Es hat sich nämlich gezeigt, dass sich hierbei besonders gut störende Verunreinigungen entfernen lassen.

Zur Entfernung von vorhandenem Sauerstoff im Kristallgitter enthält das Calciumfluoridpulver vorzugsweise zusätzlich mindestens einen Scavenger. Bevorzugte Scavenger sind PbF₂, ZnF₂, SnF₂, Grafit sowie andere niedrig schmelzende Fluoride und/oder Fluorverbindungen, die mit Sauerstoff flüchtige Verbindungen eingehen. Ein weiterer bevorzugter Scavenger ist XeF₂, welches bei Raumtemperatur fest ist, sich jedoch beim Erwärmen in Xe-Gas und F₂-Gas zersetzt und so als Niedrigtemperatur-Scavenger dient. Die bevorzugten Korngrößen der Scavenger entsprechen denen des CaF₂-Pulvers, sie können jedoch von diesen verschieden sein.

In einer besonders bevorzugten Ausführungsform enthält das beim Tempern zugesetzte Pulver feinteiligen Kohlenstoff, insbesondere Grafit.

Vorzugsweise folgt die Wärmezufuhr seitlich auf den zu tempernden Kristall und zwar unabhängig von der Länge des Diffusionsweges und unabhängig vom Verhältnis Durchmesser zur Höhe. Prinzipiell kann die Wärmezufuhr allerdings auch über die untere und obere Fläche des Kristallkörpers erfolgen. In einer weiteren bevorzugten Ausführungsform sind die Oberfläche, über welche die Wärme zugeführt wird und/oder die Oberfläche, über die keine Wärme zugeführt wird abgedeckt. Bevorzugte Abdeckungen sind Grafitmatten oder Graphitplatten.

Erfindungsgemäß umfasst das Kristallmaterial sämtliche Alkali- und Erdalkalifluoride, wie CaF₂, BaF₂, SrF₂, MgF₂ sowie NaF, LiF und KF. Auch Kristalle von gemischten Fluoriden, wie z. B. Mischkristalle von CaF₂ und SrF₂ sind erfindungsgemäß geeignet.

In einer bevorzugten Ausführungsform wird erfindungsgemäß daher derart vorgegangen, dass der gesamte Rohkristall oder ein aus einem Rohkristall orientiert herausgeschnittenes Blank, welches ein im Vergleich zum Stand der Technik wesentlich größeres Aufmaß besitzt, getempert wird. Die Temperung erfolgt in einem geeigneten Ofen bzw. einer Anlage, die die erfindungsgemäßen statischen und dynamischen Temperaturgradienten gewährleistet. Das Aufmaß wird vorzugsweise erst nach dem Tempern abgetragen. Vorzugsweise wird das Material vom Kristallmittelpunkt aus bezüglich seiner Höhe und/oder seines Durchmessers entlang des Umfangs bzw. äußeren Randes zirkumferential entfernt. In einer bevorzugten Ausführungsform beträgt das Aufmaß mindestens 5%, vorzugsweise mindestens 10% des Endmaßes bzw. der endmaßnahen Dimension, wobei ein Aufmaß bzw. Übermaß von +15%, insbesondere +20%, bevorzugt ist. Als besonders bevorzugt haben sich Aufmaße von +25 bzw. +30% erwiesen. Dabei beziehen sich die Aufmaße vorzugsweise auf den Durchmesser bzw. die Höhe des Kristalls. Soll beispielsweise das Endmaß bzw. die endmaßnahe Dimension des Kristalls 20 cm aufweisen, so wird der Kristall bei einem 20%-igen Aufmaß mit einem Durchmesser von mindestens 24 cm getempert. Ein späteres Tempern nach Entfernung des Randes, der die innere elastische Restspannung im Kristall verursacht, sollte nicht mehr stattfinden.

Mit der erfindungsgemäßen Vorgehensweise können bei CaF₂-Kristallen RMS-Werte der Brechzahlhomogenität erreicht werden, die besser als 0,025 x 10-6, insbesonders besser als 0,015 x 10-6 sind. Bezüglich der Spannungsdoppelbrechung lassen sich Werte an CaF2-Kristallen erhalten, wie sie in folgende Tabelle eingetragen sind:

**Tabelle 1**

| | <111>-Orientierung | | <100> bzw. <110>-Orientierung | |
|---|---|---|---|---|
| | gut | Insbesonders | gut | Insbesonders |
| SDB - PV-Wert in nm/cm | 0,5 | 0,2 | 2,5 | 1 |
| SDB - RMS-Wert in nm/cm | 0,15 | 0,08 | 1 | 0,35 |

Das erfindungsgemäße Verfahren eignet sich zur Herstellung von Kristallen aller Formen und aller Orientierungen. So ist es beispielsweise ohne weiteres möglich, auch Kristalle anstatt in (111)-Richtung in (100)-, oder (110)-Orientierung annähernd spannungsfrei zu erhalten, was mit den bisherigen Verfahren des Standes der Technik nicht möglich war.

Die erfindungsgemäße Herstellung von Kristallen kann nach den an sich bekannten Verfahren insbesonders nach der sog. Gradientenverfestigungsmethode (gradient solification method (GSM)) durchgeführt werden. Weitere übliche bekannte, im industriellen Maßstab durchführbare Verfahren sind beispielsweise das Bridgman-Stockbarger-Verfahren, das Vertical-Gradient-Freeze-Verfahren, das Nacken-Kyropoulos-Verfahren und das Czochralski-Verfahren, sowie Varianten dieses Verfahrens. Dabei wird jeweils polykristallines Material in einem Tiegel aufgeschmolzen und anschließend die Schmelze langsam, vorzugsweise mittels eines Impfkristalles, in gerichteter Weise erstarren gelassen. Anschließend wird bei all diesen Verfahren langsam abgekühlt, um Kristalle mit bereits geringen thermischen Verspannungen zu erhalten. Alle derartig erhaltenen Kristalle sind für das erfindungsgemäße Verfahren geeignet.

Die Erfindung betrifft nicht nur das Verfahren, sondern auch die mit dem Verfahren erhaltenen besonders spannungsarmen Kristalle mit den o.g. Werten. Die Erfindung betrifft auch die Verwendung der so erhaltenen Kristalle für optische Zwecke, insbesonders als Rohling bzw. Halbzeuge für optische Elemente. Eine bevorzugte Anwendung der so erhaltenen Kristalle betrifft die Mikrolithographie, üblicherweise die Mikrolithographie < 250 nm, insbesonders bei 248 nm bzw. bei 193 nm und vorzugsweise bei 157 nm.

Die erfindungsgemäß erhältlichen optischen Elemente sind insbesonders Prismen und Linsen, die in optischen Anordnungen, insbesonders Objektiven verwendet werden. Werden diese in der Mikrolitho- und Photographie eingesetzt, dann sind damit Stepper, Excimer-Laser, Wafer, Computerchips herstellbar, sowie integrierte Schaltungen und elektronische Geräte, die solche Schaltungen und Chips enthalten.

### Beispiele

Die Erfindung soll anhand der folgenden Beispiele näher erläutert werden.
In einer Temperung wurden vergleichsweise eine einzelne Scheibe der Orientierung (100) sowie ein größerer Kristallzylinder in (111)-naher Orientierung getempert. Die Haltezeit betrug bei diesem Prozess 100h bei 1115°C. Danach erfolgte eine Abkühlung mit einer Kühlrate kleiner als 0,3K/h bis 730°C und anschließend mit 0,85K/h bis Raumtemperatur. Aus dem Kristallvolumen wurde anschließend eine (100)-Scheibe in einer mit der Einzelscheibe vergleichbaren Geometrie geschnitten. An beiden Scheiben wurde die Spannungsdoppelbrechung gemessen. An der (100)-Einzelscheibe wurde eine SDB von 3,2 nm/cm(PV-Wert) erzielt. An der Scheibe, welche nach der Temperung aus dem Volumen herausgeschnitten wurde, konnte eine Spannungsdoppelbrechung von 0,87nm/cm(PV-Wert) erzielt werden.

## Patentansprüche

1. Verfahren zur Herstellung von insbesonders nicht 111-orientierten, Gleitebenen aufweisenden spannungsarmen, großvolumigen Kristallen mit geringer Spannungsdoppelbrechung und homogener Brechzahl, umfassend Züchten und Tempern eines Kristalles unter Relaxierung von Spannungen entlang seiner Gleitebenen durch Zuführen von Wärme unter Ausbildung eines Temperaturgradienten, **dadurch gekennzeichnet, dass** beim Tempern die Richtung der Wärmezufuhr und/oder beim Abkühlen die Wärmeabfuhr über eine Richtung erfolgt, die mit den Gleitebenen einen Winkel von größer 5° bildet.

2. Verfahren nach Anspruch 1, **dadurch gekennzeichnet, dass** der zwischen Temperaturgradient und Gleitebene ausgebildete Winkel zwischen 25 und 65° beträgt.

3. Verfahren nach Anspruch 1, **dadurch gekennzeichnet, dass** der zwischen Temperaturgradient und Gleitebene ausgebildete Winkel 35 bis 55° beträgt.

4. Verfahren nach Anspruch 1, **dadurch gekennzeichnet, dass** bei der Temperung von CaF₂-Kristallen der Winkel zwischen Temperaturgradient und Gleitebene (100) größer als 25° ist.

5. Verfahren nach einem der vorhergehenden Ansprüche, **dadurch gekennzeichnet, dass** beim Tempern der Kristall so im Temperofen ausgerichtet wird, dass seine (111)-Richtung senkrecht zur Erdoberfläche steht.

6. Verfahren nach einem der vorhergehenden Ansprüche, **dadurch gekennzeichnet, dass** die Wärmezufuhr seitlich erfolgt.

7. Verfahren nach einem der vorhergehenden Ansprüche, **dadurch gekennzeichnet, dass** bei der Temperung eines CaF₂-Kristalles die (111)-Richtung des Kristalles parallel zur Achse des Temperaturfeldes im Temperofen verläuft.

8. Verfahren nach einem der vorhergehenden Ansprüche, **dadurch gekennzeichnet, dass** nach der Temperung eines CaF₂-Kristalles der Zuschnitt in 100 oder 110-Zielorientierung erfolgt.

9. Verfahren nach einem der vorhergehenden Ansprüche, **dadurch gekennzeichnet, dass** das Tempern in einem Temperraum mit einem Temperaturfeld ausgeführt wird, welches einen statischen radialen Temperaturgradienten von kleiner 0,013 K/cm und/oder einen axialen statischen Temperaturgradienten von kleiner 0,07K/cm aufweist

10. Verfahren nach einem der vorhergehenden Ansprüche, **dadurch gekennzeichnet, dass** nach dem Tempern und Abkühlen der äußere Randbereich des Kristalles auf ein vorbestimmtes Maß abgetragen wird und danach kein weiteres Tempern mehr erfolgt.

11. CaF₂-Kristall erhältlich nach einem der Ansprüche 1 bis 7, **dadurch gekennzeichnet, dass** er eine homogene Brechzahl von < 0,025 x 10⁻⁶ (RMS-Wert) aufweist.

12. Homogener CaF₂-Kristall, erhältlich nach dem Verfahren nach einer der Ansprüche 1 bis 11 **dadurch gekennzeichnet, dass** der Kristall in 100-Richtung eine Spannungsdoppelbrechung von < 2,5 nm/cm (PV) und/oder < 1 nm/cm (RMS) aufweist.

13. Homogener CaF₂-Kristall nach Anspruch 12, **dadurch gekennzeichnet, dass** er in 100-Richtung eine Spannungsdoppelbrechung von < 1 nm/cm(PV) und/oder < 0,35 nm/cm(RMS) aufweist.

14. Verwendung von nach dem Verfahren der Ansprüche 1 bis 7 erhaltenen Kristallen, sowie den Kristallen der Ansprüche 11 - 13, als optisches Element, zur Herstellung von Steppern, Excimer-Lasern, Wafern, Computerchips, sowie integrierten Schaltungen und elektronischen Geräte, die solche Schaltungen und Chips enthalten.
